# EUROPÄISCHE PATENTANMELDUNG

(11) **EP 1 684 562 A2**
(43) Veröffentlichungstag der Anmeldung: **26.07.2006**
(21) Anmeldenummer: 06001567.4
(22) Anmeldetag: 25.01.2006
(51) Int. Cl.: H05K 7/20, H05K 5/02, G06F 1/20

(54) **Anordnung zur Kühlung von multifunktionalen Systemkonsolen**

(30) Priorität: 25.01.2005 DE 202005001212 U
(71) Anmelder: Gerätebau Felix Schulte GmbH & Co. KG, 59581 Warstein (DE)
(72) Erfinder: Seidel, Uwe, 08468 Reichenbach (DE)
(74) Vertreter: Auerbach, Bettina

(57) **Zusammenfassung**

Anordnung zur Kühlung von multifunktionalen Systemkonsolen, bestehend aus einem für die Aufnahme von Bildschirmen (1) und/oder PC-Systemen und/oder Betrachtungsflächen (2) geeigneten geschlossenen Gerätegehäuse (3), wobei am Gerätegehäuse (3) wenigstens je ein Anschlussstutzen (4) für die Kühlluftzuführung und für die Warmluftabführung angeordnet sind, wobei die Anschlussstutzen (4) mit einem vom Raumluftsystem getrennten Lüftungssystem (5) in Verbindung stehen.

## Beschreibung

Die Erfindung betrifft eine Anordnung zur Kühlung von multifunktionalen Systemkonsolen, die aus einem für die Aufnahme von Bildschirmen und/oder PC-Systemen und/oder Betrachtungsflächen geeigneten geschlossenen Gerätegehäusen bestehen. Derartige technische Lösungen werden vor allem in der Reinraumtechnik und in der Medizintechnik benötigt, in denen es auf das Vermeiden unnötiger Luftbewegungen und Wärmeeinträge in die Funktionsräume ankommt.

Multifunktionale Systemkonsolen kommen insbesondere in der Reinraumtechnik und in der Medizintechnik, beispielsweise in Operationsräumen, für die Betrachtung und Bearbeitung von digitalen und analogen Daten, beispielsweise von Plänen, Röntgenbildem oder Akteninhalten, zum Einsatz.
Im Zuge der Ausweitung computergestützter Informationssysteme ist eine zunehmende Vergrößerung der Dimensionen derartiger Systemkonsolen zu verzeichnen. Dies führt zu unerwünschten Wärmeeinträgen und/oder Luftzirkulationen in den jeweiligen Funktionsräumen. Wegen der notwendigen Wärmeabführung müssen multifunktionale Systemkonsolen in bisher bekannten Ausführungen umströmbar ausgeführt sein, was bisher die Einordnung derartiger Konsolen in Hohlwände verhindert hat.

Die Aufgabe der Erfindung besteht deshalb im Schaffen einer technischen Lösung, mit deren Hilfe die Hindernisse des Standes der Technik abgebaut werden können.
Eine fortschrittliche Lösung soll dadurch gekennzeichnet sein, dass multifunktionale Systemkonsolen in beliebiger Größe kostengünstig in Raumwände eingeordnet oder an Raumwänden positioniert werden können, ohne zu beachtlichen Wärmeinträgen und/oder zu unerwünschten Luftzirkulationen in den jeweiligen Funktionsräumen zu führen. Die Möglichkeit der keimmindemden Desinfektion der multifunktionalen Systemkonsolen soll nicht beeinträchtigt werden.

Erfindungsgemäß wird die Aufgabe durch die Merkmale des Anspruchs 1 gelöst. Die vorteilhaften Ausgestaltungen sind in den Unteransprüchen beschrieben.

Danach besteht eine Anordnung zur Kühlung von multifunktionalen Systemkonsolen aus einem für die Aufnahme von Bildschirmen und/oder PC-Systemen und/oder Betrachtungsflächen geeigneten geschlossenen Gerätegehäuse. Am Gerätegehäuse sind wenigstens je ein Anschlussstutzen für die Kühlluftzuführung und für die Warmluftabführung angeordnet. Die Anschlussstutzen stehen dabei mit einem vom Raumluftsystem getrennten Lüftungssystem in Verbindung. Auf diese Weise kann das Raumlüftungssystem, beispielsweise für einen medizinischen Operationsraum oder für einen Reinluftraum im Bereich der Mikroelektronik und/oder der Mikrobiologie, unabhängig vom Lüftungssystem zur Kühlung der Systemkonsolen ausgeführt und damit kostengünstiger gestaltet werden.
Im Lüftungssystem sind Luftührungskanäle und wenigstens ein Gebläse angeordnet.
Bevorzugt ist das Lüftungssystem in einer Hohlwand mündend angeordnet, innerhalb der oder an der sich die multifunktionale Systemkonsole befindet. Alternativ hierzu kann das Lüftungssystem auch im Nachbarraum angeordnet sein.
Es ist möglich, das Lüftungssystem mit einem die Funktionswärme abführenden Wärmetauscher zu verbinden.
Das Gerätegehäuse kann sowohl als Aufputzkonstruktion als auch in Form einer in die Raumwand integrierte Konstruktion ausgeführt sein.
In einer weiteren Ausführungsform ist zwischen dem Gerätegehäuse und
Raumwand eine Dichtrahmenkonstruktion derart angeordnet, dass eine Verbindung zwischen dem Raumluftsystem und dem Lüftungssystem sicher vermieden wird.
Das Lüftungssystem selbst kann sowohl als lokales als auch als zentrales Lüftungssystem ausgeführt sein.
Die Anordnung von wenigstens einem Strangkühlkörper als Wärmetauscherelement dient der Aufnehme der Funktionswärme des Bildbetrachtungsgerätes. Dabei kann die Luft mittels Gebläse an diesen Strangkühlkörper geführt werden oder es wird die Eigendynamik der Luftzirkulation genutzt. Damit ist das Gerät unabhängig von separaten Lüftungssystemen außerhalb des Gerätes und kann so völlig staubfrei arbeiten.

Die Vorteile der Erfindung bestehen zusammengefasst darin, dass erstens die Systemkonsole platzsparend an oder in einer Raumwand angeordnet werden kann und auf diese Weise die Raumreinhaltung erleichtert wird.
Zweitens wird der Energiehaushalt des jeweiligen Funktionsraumes nicht durch die in der Systemkonsole angeordneten Energieverbraucher, wie Beleuchtungseinrichtungen, Bildschirme, Bedienelemente und dergleichen, belastet, in dem die Systemkonsole mit einem separaten Kühlsystem oder einem eigenen integrierten und nach außen abgeschirmten Kühlsystem in Verbindung steht.
Drittens lässt sich durch die konsequente Trennung des allgemeinen Raumluftsystems vom Kühlsystem der Systemkonsole eine unnötige Belastung des Raumluftsystems vermeiden. Das spielt insbesondere dann eine beachtliche Rolle, wenn mit den Raumluftsystemen sogenannte Reinlufträume versorgt werden, in denen höchstzulässige Keim- und Partikelbelastungen aus medizinischen und/oder technologischen Gründen nicht überschritten werden dürfen.

Die Erfindung soll nachstehend an einem Ausführungsbeispiel näher erläutert werden.
In der beigefügten Zeichnung zeigen:
- Fig. 1: die schematische Ansicht einer Systemkonsole;
- Fig. 2: den schematischen Querschnitt einer in die Raumwand integrierten Systemkonsole mit in den Nachbarraum geführten Anschlussstutzen
- Fig. 3: den schematischen Querschnitt einer in die Raumwand integrierten Systemkonsole mit in die Hohlwand geführten Anschlussstutzen und
- Fig. 4: den schematischen Querschnitt einer in die Raumwand integrierten Systemkonsole mit integriertem Wärmetauscher ohne Anschlussstutzen.

### Ausführungsbeispiele

### Ausführungsbeispiel 1

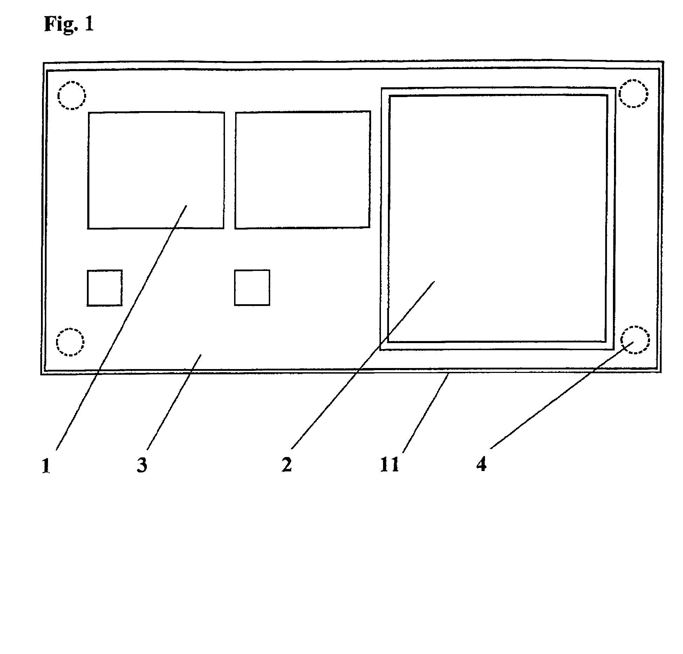

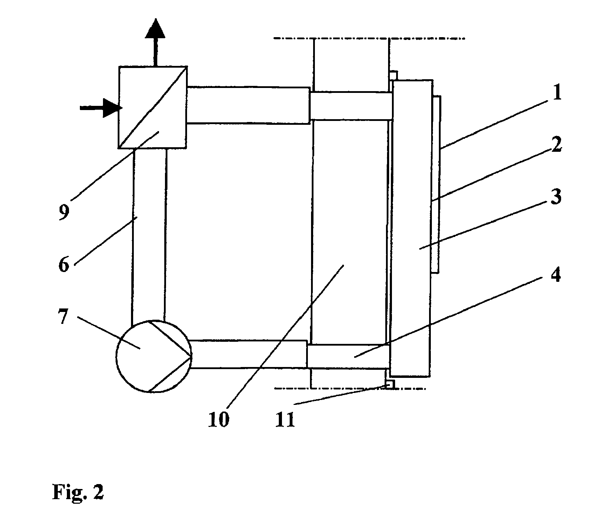

Gemäß der Figuren 1 und 2 besteht eine multifunktionale Systemkonsole aus einem Gerätegehäuse 3, das an der Ansichtsseite Bildschirm- und Betrachtungsflächen 1, 2 und an der Rückwand Anschlussstutzen 4 für die Verbindung mit dem Lüftungssystem 5 enthält.
Das Lüftungssystem 5 enthält Luftführungskanäle 6, ein Gebläse 7und einen Wärmetauscher 9, mit dessen Hilfe die fühlbare Wärme der von im Gerätegehäuse 3 abgeführten Kühlluft auf ein externes Kühlsystem übertragen wird. Zwischen der Raumwand 10 und dem Gerätegehäuse 3 ist eine Dichtrahmenkonstruktion 11 angeordnet. Die Sichtfläche des Gerätegehäuses 3 in Form von Bildschirmen 1 und Betrachtungsflächen 2 sind raumwandbündig angeordnet, so dass der Funktionsraum durch die Gerätekonsole weder hinsichtlich des Platzbedarfes, noch hinsichtlich der Verschmutzungsmöglichkeiten oder hinsichtlich des Energiehaushaltes belastet wird.

### Ausführungsbeispiel 2:

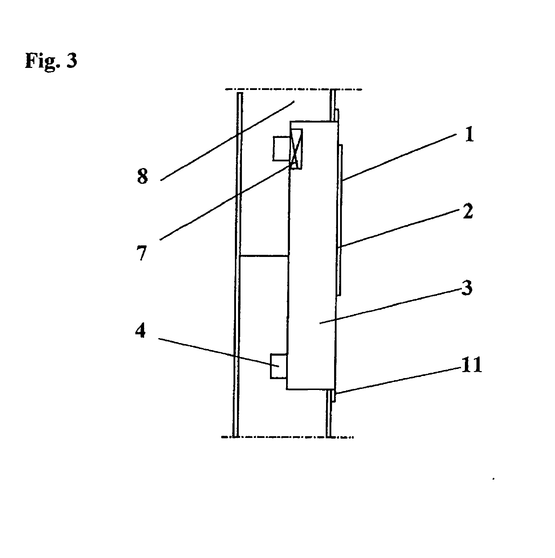

Gemäß der Figuren 1 und 3 ist das Gerätegehäuse in einer Hohlwand 8 angeordnet. Abweichend vom Ausführungsbeispiel 1 werden die Anschlussstutzen 4 der Gerätegehäuses 3 innerhalb der Hohlwand 8 mündend ausgeführt, ohne dabei eine Verbindung zu Luftführungskanälen zu besitzen. Damit wird auch der benachbarte Raum durch das Lüftungssystem für das Gerätegehäuse nicht beeinträchtigt. Das Volumen der Hohlwand reicht aus, um den notwendigen Kühleffekt zu erhalten.

### Ausführungsbeispiel 3:

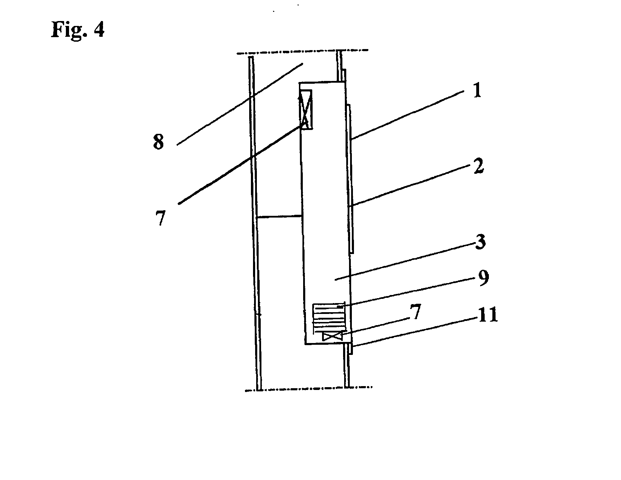

Gemäß der Figur 4 ist das Gerätegehäuse wie im Ausführungsbeispiel 2 in einer Hohlwand 8 angeordnet. Das Gerät kommt ohne Anschlussstutzen aus. Unterhalb im Gerätegehäuses 3
ist ein Strangkühlkörper als Wärmetauscher 9 angeordnet.

In diesem Strangkühlkörper sind zusätzliche Gebläse 7 integriert, die dafür sorgen, dass die durch die Energieverbraucher, wie Beleuchtungseinrichtungen, Bildschirme und Bedienelemente erzeugte Warmluft durch den Strangkühlkörper geleitet und dort abgekühlt wird. Das Gerät ist als abgeschlossenes System ausgebildet, so dass kein Luftaustausch nach Außen stattfindet.

Der Vorteil dieser Variante besteht vor allem darin, dass keine Luftableitsysteme benötigt werden und das Gerät unabhängig von einer Standortvorauswahl eingesetzt werden kann, ohne dass eine Beeinträchtigung der Raumluft stattfmdet.

### Bezugszeichenliste

- 1: Bildschirm
- 2: Betrachtungsfläche
- 3: Gerätegehäuse
- 4: Anschlussstutzen
- 5: Lüftungssystem
- 6: Luftführungskanal
- 7: Gebläse
- 8: Hohlwand
- 9: Wärmetauscher
- 10: Raumwand
- 11: Dichtrahmenkonstruktion

## Patentansprüche

1. Anordnung zur Kühlung von multifunktionalen Systemkonsolen, bestehend aus einem für die Aufnahme von Bildschirmen (1) und/oder PC-Systemen und/oder Betrachtungsflächen (2) geeigneten geschlossenen Gerätegehäuse (3), **dadurch gekennzeichnet, dass** am Gerätegehäuse (3) wenigstens je ein Anschlussstutzen (4) für die Kühlluftzuführung und für die Warmluftabführung angeordnet sind, dass die Anschlussstutzen (4) mit einem vom Raumluftsystem getrennten Lüftungssystem (5) in Verbindung stehen.

2. Anordnung zur Kühlung von multifunktionalen Systemkonsolen nach dem Anspruch 1, **dadurch gekennzeichnet, dass** im Lüftungssystem (5) Luftführungskanäle (6) und wenigstens ein Gebläse (7) angeordnet sind.

3. Anordnung zur Kühlung von multifunktionalen Systemkonsolen nach einem der Ansprüche 1 und 2, **dadurch gekennzeichnet, dass** das Lüftungssystem (5) in einer Hohlwand (8) mündend angeordnet ist.

4. Anordnung zur Kühlung von multifunktionalen Systemkonsolen nach einem der Ansprüche 1 und 2, **dadurch gekennzeichnet, dass** dass das Lüftungssystem (5) im Nachbarraum angeordnet ist.

5. Anordnung zur Kühlung von multifunktionalen Systemkonsolen nach einem der Ansprüche 1 bis 4, **dadurch gekennzeichnet, dass** das Lüftungssystem (5) mit einem die Funktionswärme abführenden Wärmetauscher (9) in Verbindung steht.

6. Anordnung zur Kühlung von multifunktionalen Systemkonsolen nach einem der Ansprüche 1 bis 5, **dadurch gekennzeichnet, dass** das Gerätegehäuse (3) als Aufputzkonstruktion angeordnet ist.

7. Anordnung zur Kühlung von multifunktionalen Systemkonsolen nach einem der Ansprüche 1 bis 5, **dadurch gekennzeichnet, dass** das Gerätegehäuse (3) als in die Raumwand (10) integrierte Konstruktion angeordnet ist.

8. Anordnung zur Kühlung von multifunktionalen Systemkonsolen nach einem der Ansprüche 1 bis 7, **dadurch gekennzeichnet, dass** zwischen Gerätegehäuse (3) und Raumwand (10) eine Dichtrahmenkonstruktion (11) angeordnet ist.

9. Anordnung zur Kühlung von multifunktionalen Systemkonsolen nach einem der Ansprüche 1 bis 8, **dadurch gekennzeichnet, dass** das Lüftungssystem (5) als lokales oder zentrales Lüftungssystem (5) ausgeführt ist.

10. Anordnung zur Kühlung von multifunktionalen Systemkonsolen, bestehend aus einem für die Aufnahme von Bildschirmen (1) und/oder PC-Systemen und/oder Betrachtungsflächen (2) geeigneten geschlossenen Gerätegehäuse (3), **dadurch gekennzeichnet, dass** innerhalb des Gerätegehäuse (3) wenigstens ein der Wärmeaufnahme dienender Strangkühlkörper (9) angeordnet ist.
